Europäisches Patentamt

European Patent Office

Office européen des brevets

(11) Veröffentlichungsnummer: **0 474 082 A1**

# EUROPÄISCHE PATENTANMELDUNG

(21) Anmeldenummer: **91114269.3**

(22) Anmeldetag: **26.08.91**

(51) Int. Cl.5: **H01R 13/64**, H05K 7/14

(30) Priorität: **04.09.90 DE 4028013**

(43) Veröffentlichungstag der Anmeldung:
**11.03.92 Patentblatt 92/11**

(84) Benannte Vertragsstaaten:
**AT BE CH DE FR GB IT LI NL SE**

(71) Anmelder: **SIEMENS AKTIENGESELLSCHAFT
Wittelsbacherplatz 2
W-8000 München 2(DE)**

(72) Erfinder: **Zell, Karl, Dipl.-Ing.
Moritz-von Schwind-Weg 80
W-8134 Niederpöcking(DE)**
Erfinder: **Heimüller, Hans-Jost
Schafgarten 9
W-6724 Dudenhofen(DE)**
Erfinder: **Seidel, Peter
Mittenwalderstrasse 256
W-8038 Gröbenzell(DE)**

(54) Codiervorrichtung mit integrierten Sonderkontakten für auf eine Rückwandverdrahtung aufsteckbare elektrische Baugruppen.

(57) Die Erfindung betrifft eine Codiervorrichtung für auf eine Rückwandverdrahtung aufsteckbare Baugruppen, wobei die Rückwandverdrahtung aus einer Rückwandleiterplatte (3) mit eingesetzten Kontaktmessern (10) und darauf aufsteckbaren als einseitig offene rechtwinkelige Gehäuse ausgebildeten Messerleisten (1) zur Aufnahme von Federleisten (2), die mit elektrischen Baugruppen fest verbunden sind, besteht, und wobei sowohl die Messerleisten (1) als auch die Federleisten (2) aus einzelnen Teilleisten bestehen, deren Längen dem ein- oder mehrfachen der Länge eines vorgegebenen Teilsegments entsprechen.

Teilleisten, sowohl der Messerleiste (1) als auch der Federleiste (2) von der Länge eines Teilsegments, sind teilweise als korrespondierende Codiereinheiten (5,6) in Verbindung mit Sonderkontakten (7,8) ausgebildet und an beliebiger Stelle der Leisten anbringbar.

FIG 7

Die Erfindung betrifft eine Codiervorrichtung für auf eine Rückwandverdrahtung aufsteckbare Baugruppen, wobei die Rückwandverdrahtung aus einer Rückwandleiterplatte mit eingesetzten Kontaktmessern und darauf aufsteckbaren als einseitig offene rechtwinkelige Gehäuse ausgebildeten Messerleisten zur Aufnahme von Federleisten, die mit elektrischen Baugruppen fest verbunden sind, besteht, und wobei sowohl die Messerleisten als auch die Federleisten aus einzelnen Teilleisten bestehen, deren Längen dem ein- oder mehrfachen der Länge eines vorgegebenen Teilsegments entsprechen.

Derartige Rückwandverdrahtungen sind z. B. aus dem deutschen Gebrauchsmuster 8509375 bekannt. Ihr Vorteil besteht darin, daß bei einer mit rasterförmig angeordneten Stiften belegten Rückwandleiterplatte eine einzige Ausführungsform für alle sich möglicherweise ergebenden Anforderungen genügt.

Für derartige Rückwandverdrahtungen sind die herkömmlichen Codiervorrichtungen nicht geeignet, da ein Teil der Codiervorrichtung neben der Messerleiste angeordnet sein muß, und damit eine optimale Bestückung der Rückwandleiterplatte mit Baugruppen nicht mehr realisierbar ist. Eine derartige herkömmliche Codiervorrichtung für eine aus Messer- und Federleiste bestehende Steckverbindung ist z. B. aus dem deutschen Gebrauchsmuster 8428427 bekannt. Auch für den Fall, daß die Codiervorrichtungen mit zusätzlichen Sonderkontakten ausgerüstet sein sollen, ist eine optimale Bestückung nicht möglich. In diesen Fällen ist eine modulare Anordnung, und damit eine beliebige Anordnung innerhalb des Steckers nicht möglich.

Aufgabe der vorliegenden Erfindung ist es, eine Codiervorrichtung der eingangs genannten Art mit integrierten Sonderkontakten anzugeben, die bei einer Rückwandleiterplatte mit eingesetzten Kontaktmessern eine optimale Bestückung der Rückwandleiterplatte mit Baugruppen ermöglicht.

Diese Aufgabe wird erfindungsgemäß für eine Codiervorrichtung der oben genannten Art dadurch gelöst, daß Teilleisten sowohl der Messerleiste als auch der Federleiste von der Länge eines Teilsegments als korrespondierende Codiereinheiten mit integrierten Sonderkontakten ausgebildet sind und an beliebigen Stellen der Leisten anbringbar sind, wobei jeweils anstelle einer vorgegebenen Anzahl von Kontaktmessern und den dazu korrespondierenden Aufnahmefedern Codiereinheiten und Sonderkontakte vorgesehen sind.

Da bei der erfindungsgemäßen Codiervorrichtung die Codiereinheiten mit den Sonderkontakten innerhalb der Abmessungen der Codierleistung angeordnet sind, kann bei der erfindungsgemäßen Codiervorrichtung die Rückwandleiterplatte optimal mit Baugruppen bestückt werden. Innerhalb einer vorgegebenen Teilung können Codiermöglichkeiten und Sonderkontakte gemeinsam untergebracht und modular in Steckverbindermodulen angeordnet werden. Bei Aufbauten ist also innerhalb der modularen Teilung eine beliebige Anordnung innerhalb der Steckverbinder möglich.

Eine zweckmäßige Ausgestaltung der erfindungsgemäßen Codiervorrichtung ist dadurch gekennzeichnet, daß die Sonderkontakte in Längsrichtung mittig angeordnet sind und daß zu beiden Seiten der Sonderkontakte Codiereinheiten in unterschiedlicher Zahl angeordnet sind. Diese Anordnung eignet sich besonders für miniaturisierte Sonderkontakte.

Eine andere zweckmäßige Ausgestaltung der erfindungsgemäßen Codiervorrichtung ist dadurch gekennzeichnet, daß die Sonderkontakte auf einer Längsseite des Teilsegments außermittig angeordnet sind und daß auf der anderen Längsseite mehrere Codiereinheiten in Reihe angeordnet sind. Diese Anordnungen eignet sich besonders für herkömmliche genormte Sonderkontakte.

Eine weitere zweckmäßige Ausgestaltung der erfindungsgemäßen Codiervorrichtung ist dadurch gekennzeichnet, daß die Codiereinheiten einerseits aus Vertiefungen und andererseits aus Stiften bestehen. Diese Ausführungsform ermöglicht auf einfache Weise eine große Anzahl von Codiermöglichkeiten.

Im folgenden wird die Erfindung anhand eines in Zeichnung dargestellten Ausführungsbeispiels näher erläutert.

Es zeigen

Figur 1     die perspektivische Ansicht einer Messerleiste zur Aufnahme der Kontaktmesser der Rückwandleiterplatte,

Figur 2     die perspektivische Ansicht einer entsprechenden Federleiste zum Aufstecken auf die Kontaktmesser,

Figur 3     ein Querschnitt durch eine Messerleiste einer Codiervorrichtung mit mittig angeordneten Sonderkontakten,

Figur 4     ein Querschnitt durch eine Federleiste einer Codiervorrichtung mit mittig angeordneten Sonderkontakten,

Figur 5     eine Draufsicht auf eine Messerleiste einer Codiervorricntung mit mittig angeordneten Sonderkontakten,

Figur 6     eine Draufsicht auf eine Federleiste einer Codiervorrichtung mit mittig angeordneten Sonderkontakten,

Figur 7     ein Querschnitt durch eine Messerleiste einer Codiervorrichtung mit außermittig angeordneten Sonderkontakten, und

Figur 8     ein Querschnitt durch eine Federleiste einer Codiervorrichtung mit außermittig angeordneten Sonderkontakten.

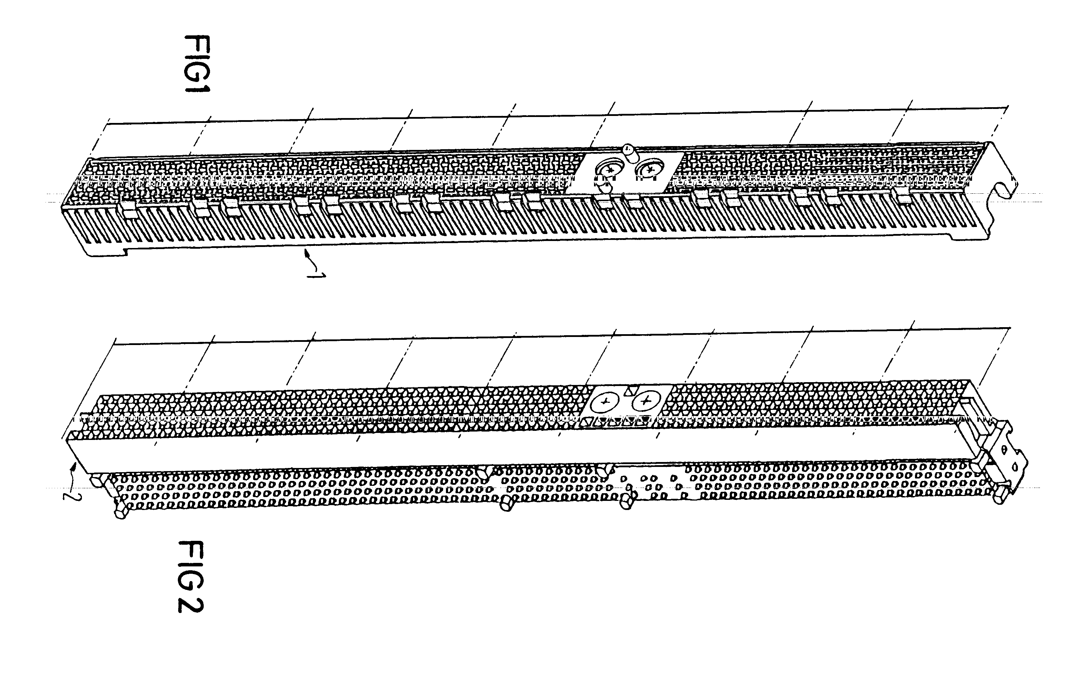

Figur 1 zeigt eine Messerleiste 1, die im wesentlichen aus einem einseitig offenen rechtwinkeligen Gehäuse besteht, durch dessen Bodenöffnungen Kontaktmesser der Rückwandleiterplatte 3 stoßen. Figur 2 zeigt die dazugehörige Federleiste 2, die fest mit einer Baugruppenleiterplatte 4 verbunden ist. Sowohl die Messerleisten 1 als auch die Federleisten 2 bestehen aus einzelnen Teilleisten, deren Längen dem ein- oder mehrfachen der Länge eines vorgegebenen Teilsegments entsprechen, wie es in den Figuren 1 und 2 angedeutet ist.

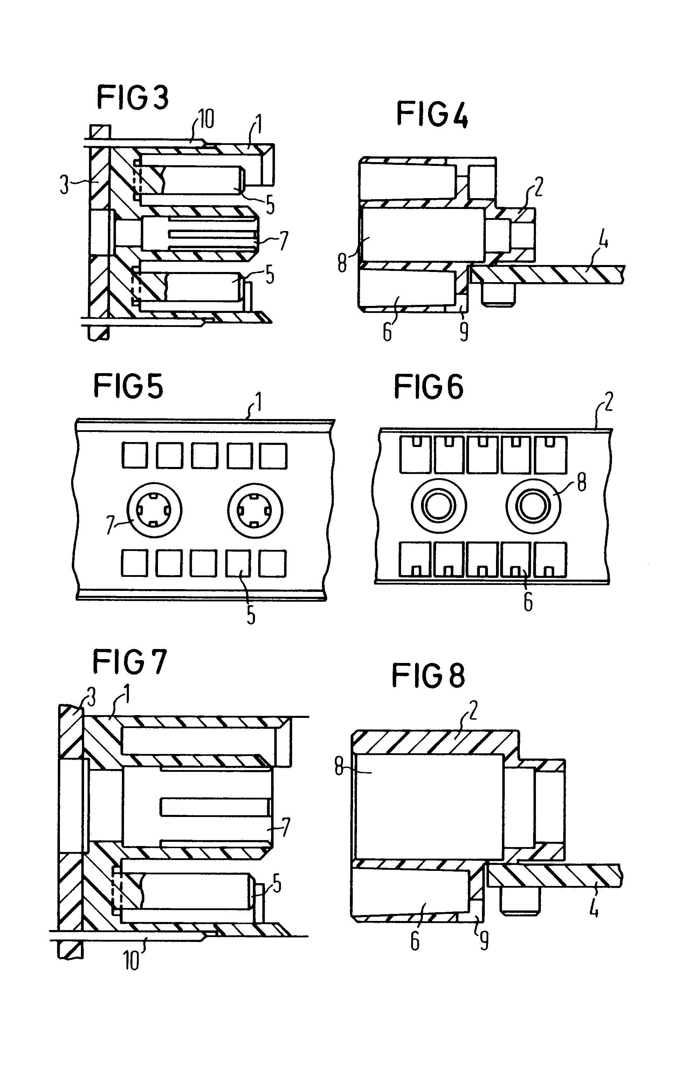

In den Figuren 3 bis 6 ist nun eine Ausführungsform der erfindungsgemäßen Codiervorrichtung dargestellt, bei welcher die Sonderkontakte mittig angeordnet sind. In den betreffenden Figuren ist zu erkennen, daß die Sonderkontaktstecker 7 sowie die Sonderkontaktbuchsen 8 hintereinander entlang der Längsachse von Messerleiste 1 und Federleiste 2 angeordnet sind. Je nach Größe des Teilsegments kann eine unterschiedliche Anzahl von Sonderkontakten vorgesehen sein. Auf beiden Seiten der Sonderkontakte sind in Längsrichtung auf der Messerleiste 1 die Codierstifte 5 und auf der Federleiste 2 die Codierkammern 6 angeordnet. Die Codierstifte 5 können abgebrochen werden und in die Codierkammern 6 eingedrückt werden. Eine Freisparung 9 im entsprechenden Teilsegment der Federleiste 2 ermöglicht ein Entfernen der eingedrückten Codierstifte. Ebenso ist das Eindrücken separater, nicht abgebrochener Codierstifte in die Codierkammern möglich.

Die in den Figuren 3 bis 6 dargestellte Ausführungsform eignet sich insbesondere für miniaturisierte Sonderkontakte, wobei es sich im Einzelnen um Hochstrom-, KOAX- oder LWL-Kontakte handeln kann. Die in den Figuren 7 und 8 dargestellte Ausführungsform der erfindungsmäßen Codiereinrichtung dagegen eignet sich insbesondere für die Verwendung von nach DIN 41626 genormten Sonderkontakten, wobei es sich auch bei diesen Kontakten entweder um Hochstrom-, KOAX- oder LWL-Kontakte handeln kann.

Aufgrund der Größe der genormten Sonderkontakte sind diese außermittig angeordnet und es sind nur noch an einer Längsseite Codiereinheiten in Reihe angeordnet.

## Patentansprüche

1. Codiervorrichtung mit integrierten Sonderkontakten für auf eine Rückwandverdrahtung aufsteckbare elektrische Baugruppen, wobei die Rückwandverdrahtung aus einer Rückwandleiterplatte mit eingesetzten Kontaktmessern und darauf aufsteckbaren als einseitig offene rechtwinkelige Gehäuse ausgebildete Messerleisten zur Aufnahme von Federleisten, die mit elektrischen Baugruppen festverbunden sind, besteht, und wobei sowohl die Messerleisten als auch die Federleisten aus einzelnen Teilleisten bestehen, deren Längen dem ein- oder mehrfachen der Länge eines vorgegebenen Teilsegments entsprechen,
   **dadurch gekennzeichnet,**
   daß Teilleisten sowohl der Messerleiste (1) als auch der Federleiste (2) von der Länge eines Teilsegments als korrespondierende Codiereinheiten mit integrierten Sonderkontakten (5,6,7,8) ausgebildet sind und an beliebigen Stellen der Leisten (1,2) anbringbar sind, wobei jeweils anstelle einer vorgegebenen Anzahl von Kontaktmessern (10) und der dazu korrespondierenden Aufnahmefedern Codiereinheiten und Sonderkontakte (5,6,7,8) vorgesehen sind.

2. Codiervorrichtung nach Anspruch 1, **dadurch gekennzeichnet,**
   daß die Sonderkontakte (7,8) in Längsrichtung mittig angeordnet sind und daß zu beiden Seiten der Sonderkontakte (7,8) Codiereinheiten (5,6) in unterschiedlicher Zahl angeordnet sind.

3. Codiervorrichtung nach Anspruch 1, **dadurch gekennzeichnet**,
   daß die Sonderkontakte (7,8) auf einer Längsseite des Teilsegments außermittig angeordnet sind und daß auf der anderen Längsseite mehrere Codiereinheiten (5,6) in Reihe angeordnet sind.

4. Codiervorrichtung nach Anspruch 1, **dadurch gekennzeichnet,**
   daß die Codiereinheiten (5,6) einerseits aus Vertiefungen und andererseits aus Stiften bestehen.

EP 0 474 082 A1

FIG 1

FIG 2

FIG 3

FIG 4

FIG 5

FIG 6

FIG 7

FIG 8

**Europäisches Patentamt**

# EUROPÄISCHER RECHERCHENBERICHT

Nummer der Anmeldung

**EP 91 11 4269**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | DE-U-8 905 361 (SIEMENS)<br>* Seite 2, Zeilen 6-21; Seite 3, Zeilen 1-22; Seite 4, Zeile 29 - Seite 5, Zeile 3; Seite 5, Zeilen 19-22; Figuren 1-3 *<br>– – – | 1,3,4 | H 01 R 13/64<br>H 05 K 7/14 |
| Y | DE-U-8 620 526 (SIEMENS)<br>* Seite 2, Zeilen 13-23; Seite 3, Zeile 24 - Seite 4, Zeile 6; Seite 6, Zeilen 29-34; Figur 1 *<br>– – – – – | 1,3,4 | |

**RECHERCHIERTE SACHGEBIETE (Int. Cl.5)**

H 01 R 13/00
H 05 K 7/00

Der vorliegende Recherchenbericht wurde für alle Patentansprüche erstellt

| Recherchenort | Abschlußdatum der Recherche | Prüfer |
|---|---|---|
| Berlin | 02 Dezember 91 | ALEXATOS G |